# EUROPEAN PATENT SPECIFICATION

(11) **EP 3 244 135 B1**
(45) Date of publication and mention of the grant of the patent: **30.12.2020**
(21) Application number: 17170185.7
(22) Date of filing: 09.05.2017
(51) Int. Cl.: F24H 1/43, F24H 9/02

(54) **HEAT EXCHANGER**
WÄRMETAUSCHER
ECHANGEUR DE CHALEUR

(30) Priority: 10.05.2016 NL 2016755
(43) Date of publication of application: 15.11.2017
(73) Proprietor: Remeha B.V., 7332 BD Apeldoorn (NL)
(72) Inventor: VAN VLIET, Sebastiaan Rogier, 7332 BD Apeldoorn (NL); VAN DIEPEN, Bart Gerardus Dirk, 7332 BD Apeldoorn (NL)
(74) Representative: V.O.

(56) References cited:
- WO-A1-2004/036121
- WO-A1-2007/066369
- WO-A1-2011/092332
- WO-A1-2012/156954
- WO-A1-2016/001852
- WO-A2-2005/080900

## Description

The invention relates to a heat exchanger for a central heating application for heating CH water and/or for sanitary water heating. The heat exchanger comprises a coil shaped water pipe assembly.

### BACKGROUND

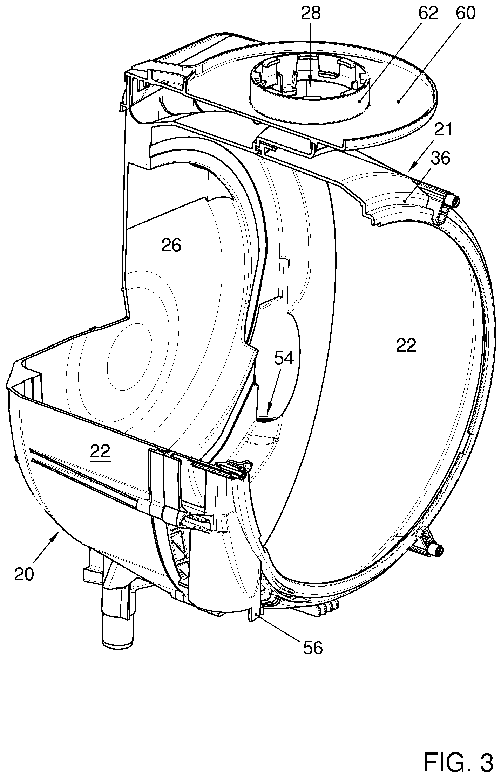

From US2006/0196450 A1 (Rocco Giannoni) a heat exchanger is known which comprises a coil shaped heat exchanger pipe assembly which is received in a housing. The objective of that publication was to be able to provide a heat exchanger whose housing is made from plastic instead of from metal, so that the heat exchanger as a whole can be made of lighter weight. As described in the publication in question, the coil shaped heat exchanger pipe assembly of the coil heat exchanger tends to expand in axial direction under the influence of the internal fluid pressure prevailing therein. The solution chosen in the publication in question is to provide a special construction which is not part of the housing, and which comprises ties, an annular bottom plate and a cover plate. The ties, the bottom plate and the cover plate are connected with one another, thereby axially clamping the coil shaped heat exchanger pipe assembly. This assembly is shown in Fig. 3 of the publication in question. The plastic housing consists of a first and a second housing part. The first housing part comprises two connection stubs for passing the two ends of the heat exchanger pipe assembly. The heat exchanger pipe assembly is placed in the first housing part. Thereupon the second housing part is connected with the first housing part and finally, with the help of a crimp connection, the cover plate is connected with an opening edge which is bounded by the plastic housing formed by the first and the second housing part. Further, to protect the plastic housing from the hot gases, in the housing a heat shield is arranged which is situated between the cylindrical surface of the plastic housing parts and the heat exchanger pipe assembly. In the cover plate there is a central opening which is closed off with a burner cover assembly. With the aid of bolt/nut connections the burner cover assembly is bolted to the cover plate, whereby the bolts are under strain of tension in axial direction. Between the burner cover assembly and the cover plate there is a seal which is compressed in axial direction by the tension prevailing in the bolts. Such a heat exchanger is marketed by Sermeta in various sizes, with the designations FHC for central heating and ISO Tankless and ISO Storage for sanitary water heating.

A similar heat exchanger is described in WO 2011/092332 A1 (Rocco Giannoni), an English-language equivalent of which is US2012/0312513 A1. Claim 1 is differentiated from this publication. The drawings are of a schematic nature, the description, however, is clear. According to paragraph [0078] the housing may be made from metal, in particular stainless steel. According to paragraph [0079], however, the housing is preferably made from plastic, in particular two plastic halves. The plane in which the two halves are joined together is not clearly and unambiguously disclosed in the description but Figure 3 seems to suggest that the separating plane coincides with the plane defined by the line I-I in that figure. Of relevance is that paragraph [0088] discloses that when the housing is made from plastic, mechanical means are present for keeping the spiral bundles axially together and that these mechanical means are configured as described in FR 2 846 075 and FR 2 850 451. FR 2 846 075 belongs to the same family as US2006/0196450 A1 already mentioned and described above. The teaching of WO 2011/092332 A1 and US2012/0312513 A1 is therefore the same as that of US2006/0196450, namely, when the housing is made from plastic, use is to be made of a special construction which is not part of the housing, and which comprises ties, an annular bottom plate and a cover plate. The ties, the bottom plate and the cover plate are connected with one another, thereby axially clamping the coil shaped heat exchanger pipe assembly.

### SUMMARY OF THE INVENTION

A drawback of this known apparatus is that the construction of ties, bottom plate and cover plate for clamping the heat exchanger pipe assembly in axial direction is costly and that the manufacture of the heat exchanger is relatively costly in view of the relatively large number of assembly operations and the crimping operation. Moreover, there is a hazard of hot flue gases escaping between the burner cover assembly and the cover plate when the nuts of the bolt and nut assemblies with which the burner cover assembly is connected to the cover plate are not properly tightened and so there is insufficient tension in the bolts.

The invention contemplates a heat exchanger assembly comprising a coil shaped heat exchanger pipe assembly with a plastic housing, where the above described disadvantages are at least partially resolved.

To this end, the invention provides a heat exchanger assembly which comprises at least one coil shaped heat exchanger pipe assembly for passing through a fluid. The heat exchanger pipe assembly has an inlet and an outlet and comprises coil windings extending concentrically around a coil axis. The heat exchanger pipe assembly on a radial inner side thereof bounds an inner space which comprises a burner chamber part. The heat exchanger assembly further comprises a housing in which the heat exchanger pipe assembly is received. The housing comprises a circumferential wall which is substantially cylindrical and which defines a housing axis which substantially coincides with the coil axis. An inner diameter of the circumferential wall is greater than an outer diameter of the heat exchanger pipe assembly. As a result, a flue gas transport gap extends between the heat exchanger pipe assembly and the circumferential wall. The housing further comprises a first end wall which closes off a first end of the circumferential wall, as well as a second end wall which closes off a second end of the circumferential wall at least partially and comprises a central burner cover opening. The housing also comprises an exhaust for flue gases. Further, the heat exchanger assembly comprises a burner cover which is detachably connected with the second end wall of the housing. The burner cover closes off the central burner cover opening and comprises an air/fuel mixture connection. The heat exchanger assembly furthermore comprises a burner which is connected with the burner cover. The burner extends substantially concentrically around a burner axis which substantially coincides with the housing axis and the coil axis. The burner is situated in the burner chamber part and is in fluid communication with the air/fuel mixture connection. In use, flue gases produced by the burner flow via the burner chamber part between the coil windings into the flue gas transport gap. Eventually, the flue gases then leave the housing via the exhaust. This can proceed directly from the flue gas transport gap, but in preferred embodiments the flue gas will pass the coil windings one more time or several more times before leaving the housing via the exhaust. The heat exchanger assembly is characterized in that the housing is divided in a first and a second housing part which are both made from plastic, wherein the first housing part includes the first end wall, and wherein the second housing part includes the second end wall. The first and/or the second housing part include the circumferential wall. Moreover, the heat exchanger pipe assembly is clamped in axial direction between the first and the second plastic end wall of the housing, while axial expansion forces exerted by the coil shaped heat exchanger pipe assembly, which occur in use as a result of an internal fluid pressure, are absorbed by the plastic first and second end walls of the housing.

Axial clamping of the coil shaped heat exchanger pipe assembly is done by the plastic housing itself. When connecting the two housing parts with each other, with that same operation the heat exchanger pipe assembly is clamped between the first and the second end wall. Consequently, no extra assembly operations are necessary for clamping the heat exchanger pipe assembly with the extra ties between an additional bottom plate and cover plate as in US'450.

Providing a metal end wall for taking up the burner cover, with the metal end wall connected to a plastic housing by a crimp connection as in US'450, is not necessary anymore either.

The heat exchanger assembly can be used for CH water heating, sanitary water heating, or for a combination of both.

As a result of the fewer number of assembly operations and the fewer number of parts, the heat exchanger according to the invention can be produced at a lower cost price.

Further elaborations of the heat exchanger assembly are described in the subclaims and will hereinafter, with reference to the figures, be further clarified.

### BRIEF DESCRIPTION OF THE FIGURES

Fig. 1 shows a first perspective view of the heat exchanger in assembled condition with a quarter part of the heat exchanger cut away to provide a view of the inside;
Fig. 2 shows a second perspective view of the heat exchanger in assembled condition with a quarter part of the heat exchanger cut away to provide a view of the inside;
Fig. 3 shows a perspective view of an example of the housing;
Fig. 4 shows a second perspective view of the housing represented in Fig. 3;
Fig. 5 shows a perspective view of the first housing part with a heat exchanger pipe assembly placed therein;
Fig. 6 shows an example of a levelling ring;
Fig. 7 shows the perspective view of Fig. 5 after placement of the levelling ring;
Fig. 8 shows the perspective view of Fig. 7 after placement of a cover seal on the levelling ring;
Fig. 9 shows a cross-sectional view of a part of the heat exchanger after placement of the second housing part;
Fig. 10 shows a similar cross-sectional view to Fig. 9 after placement of the burner cover.

### DETAILED DESCRIPTION

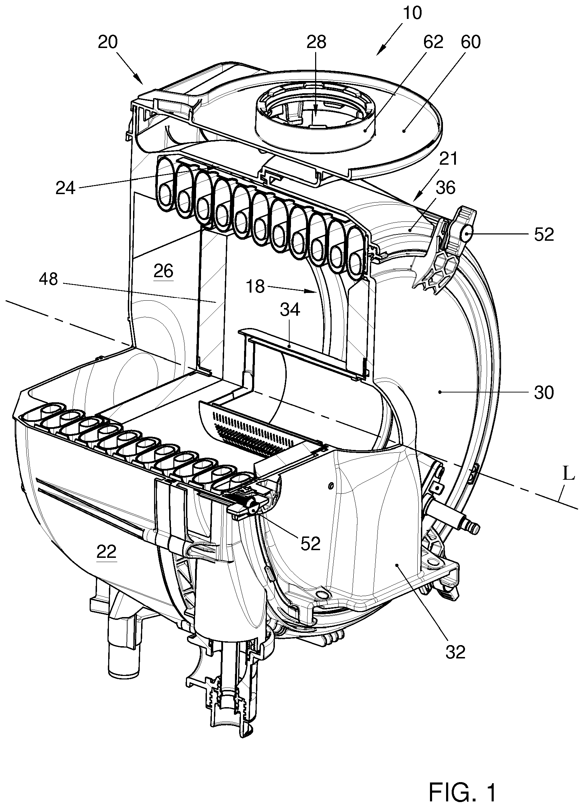

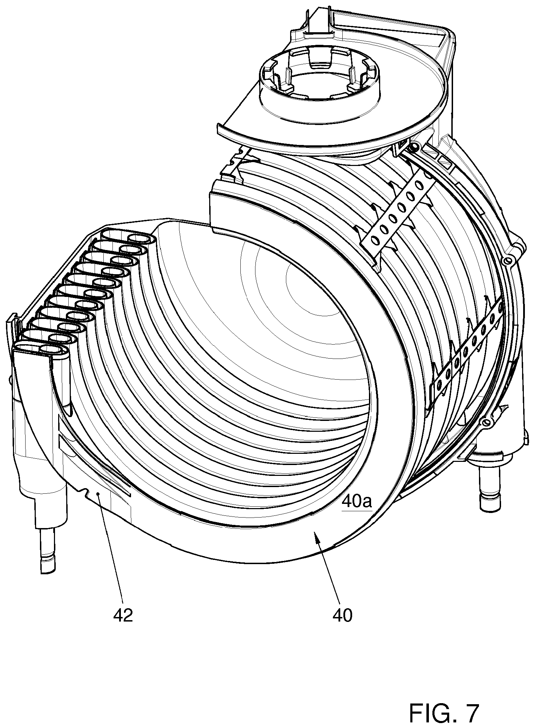

Figures 1-10 show an example of a heat exchanger assembly 10 in which various embodiments, including the main aspect of the invention, are embodied. It is noted that the embodiments described hereinafter can also be applied independently of each other and that the invention is not limited to the examples shown in the figures. The reference numerals are used herein for clarification but have no limiting effect. An embodiment may also be implemented differently than represented in the example shown in the figures.

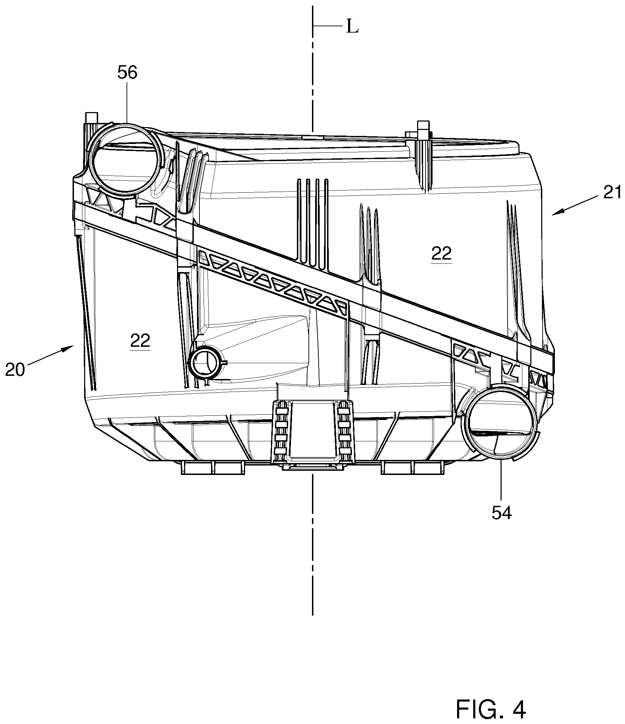

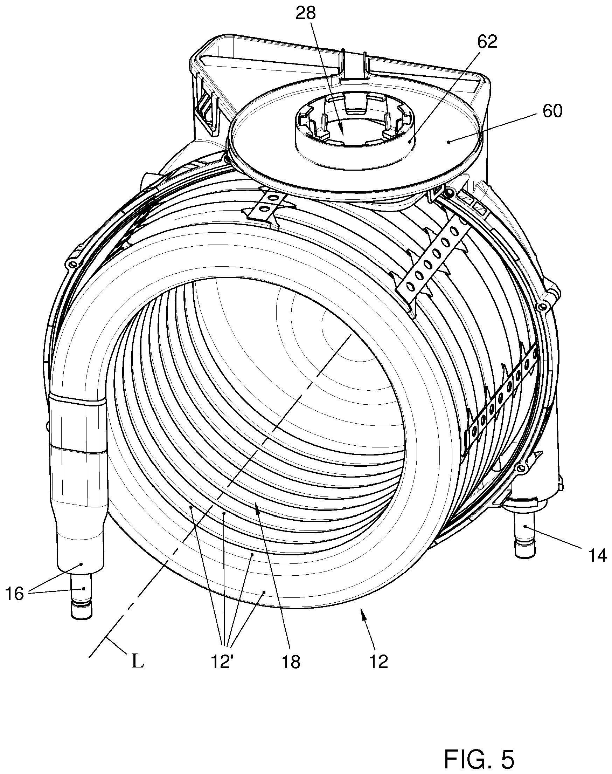

In most general terms, the invention provides a heat exchanger assembly 10 which comprises at least one coil shaped heat exchanger pipe assembly 12 (see Figure 5) for passing through a fluid to be heated. The heat exchanger pipe assembly 12 has an inlet 14 and an outlet 16, and the heat exchanger pipe assembly 12 comprises coil windings 12' extending concentrically around a coil axis L. The heat exchanger pipe assembly 12 on a radial inner side thereof bounds an inner space which defines a burner chamber part 18. The heat exchanger assembly 10 further comprises a housing 20, 21 (see Figures 3 and 4) in which the heat exchanger pipe assembly 12 is received. The housing 20, 21 comprises a circumferential wall 22 which is substantially cylindrical and which defines a housing axis which substantially coincides with the coil axis L. An inner diameter of the circumferential wall 22 is greater than an outer diameter of the heat exchanger pipe assembly 12, such that a flue gas transport gap 24 extends between the heat exchanger pipe assembly 12 and the circumferential wall 22. Further, the housing comprises a first end wall 26 which closes off a first end of the circumferential wall 22. Finally, the housing comprises an exhaust 28 for flue gases. In the example shown in the figures, the exhaust 28 is bounded by a third housing part 60 which adjoins an exhaust opening present in the first housing part 20. The third housing part 60 comprises a cylindrical connecting piece 62 to which a flue gas discharge duct can be connected in a simple manner. The heat exchanger assembly 10 further comprises a burner cover 30 which is detachably connected with the housing 20, 21 and which comprises an air/fuel mixture connection 32. Connected with the burner cover 30 is a burner 34 which extends substantially concentrically around a burner axis substantially coinciding with the housing axis and the coil axis L. The burner 34 is situated in the burner chamber part 18 and is in fluid communication with the air/fuel mixture connection 32. In use, flue gases produced by the burner 34 flow via the burner chamber part 18 between the coil windings 12' into the flue gas transport gap 24. Finally, the flue gases leave the housing 20, 21 via the exhaust 28. Between their entering the flue gas transport gap 24 and their leaving the housing 20, 21 via the exhaust 28, the flue gases, in an embodiment of the heat exchanger assembly, may again pass the coil windings 12' one or more times, thus in effect being brought into heat exchanging contact with the heat exchanger pipe assembly 12 several times.

In themselves, the above-mentioned features of the heat exchanger assembly 10 are known from US2006/0196450 A1.

The heat exchanger 10 is characterized according to the invention in that the housing 20, 21 is divided into a first 20 and a second 21 housing part which are both made from plastic, wherein the first housing part 20 includes the first end wall 26 and wherein the second housing part 21 includes a second end wall 36, which second end wall 36 closes off a second end of the circumferential wall 22 at least partially and comprises a central burner cover opening which is closed off with the burner cover 30. Here, the first 20 and/or the second 21 housing part define the circumferential wall 22 and the heat exchanger pipe assembly 12 is clamped in axial direction between the first 26 and the second 36 plastic end wall of the housing 20, 21.

The advantages of such a heat exchanger assembly 10 have already been described hereinbefore in the section "summary of the invention", which is now referred to.

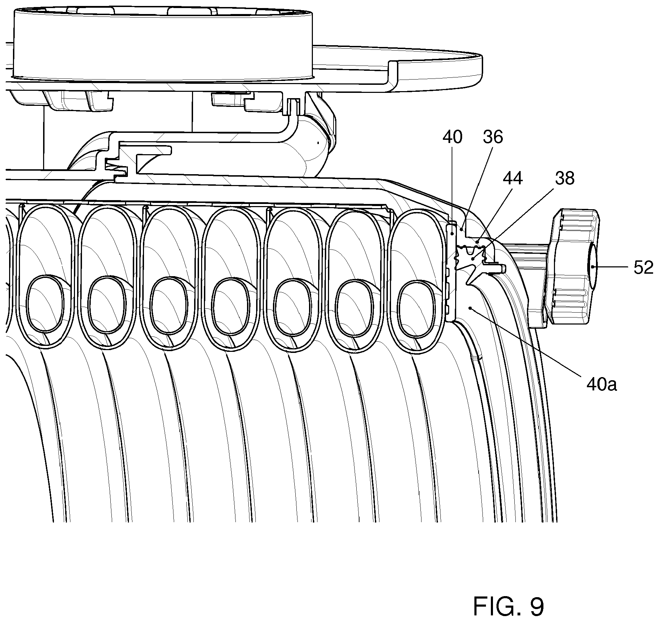

In an embodiment, the burner cover opening can have a diameter that is greater than an inner diameter of the heat exchanger pipe assembly 12. A radial outer area of the burner cover 30 is then in heat exchanging contact with the heat exchanger pipe assembly 12, such that in use the radial outer area of the burner cover 30 is cooled by the heat exchanger pipe assembly 12. For this, see, for example, Figure 9.

Due to the radial outer area of the burner cover being cooled by the heat exchanger pipe assembly 12, no metal mount that is part of the housing is necessary for the burner cover 30. This is because due to the outer circumference of the burner cover 30 being relatively cool, a direct contact, possibly with interposition of a cover seal 38, between the burner cover 30 and the plastic second housing part 21 is possible.

In an embodiment, a cover seal 38 may be confined between the cooled radial outer area of the burner cover 30 and a part of the second plastic end wall 36 that bounds the central burner cover opening.

If the cover seal 38 for some reason should not seal properly, the flue gases, before reaching the gap that is sealed by the cover seal 38, first flow along the relatively cool coil shaped heat exchanger pipe assembly 12 before being able to escape from the housing 20, 21 along the cover seal 38. Therefore, no hot flue gases flow out. The flexible cover seal 38 is therefore situated in a relatively cool area. As a result, the freedom regarding the choice of the material of the cover seal 38 is relatively great, since there are no particular requirements as regards the temperature resistance of the cover seal 38.

The cover seal 38 has at least a twofold close-off function in that it closes off two potential leakage flows, namely:
- flue gas coming from the burner chamber part 18 seeking to escape to the outside is stopped;
- flue gas coming from the flue gas transport gap 24 seeking to escape to the outside is stopped.

Moreover, the cover seal 38 can further fulfill a heat insulating function which limits transfer of heat from the burner cover 30 to the plastic, second end wall 36.

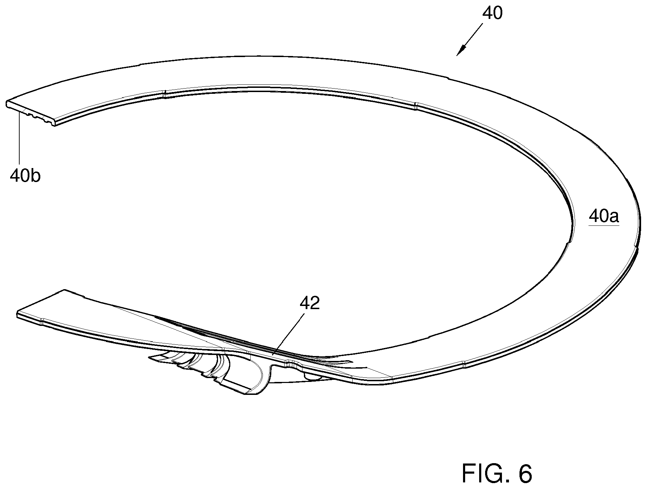

In an embodiment, the heat exchanger assembly 10 may comprise a levelling ring 40 having a rising surface 42 (see Figures 6, 7, 9 and 10). Such a levelling ring 40 is situated between the coil winding 12' that extends closest to burner cover 30, and the burner cover 30. A side 40a of the levelling ring 40 facing the burner cover 30 forms a first contact face which abuts in heat-conducting contact against the burner cover 30. A side 40b of the levelling ring 40 facing the heat exchanger pipe assembly 12 forms a second contact face which abuts in heat conducting contact against the coil winding 12' that extends closest to the burner cover 30. The levelling ring 40 is made from heat conducting material.

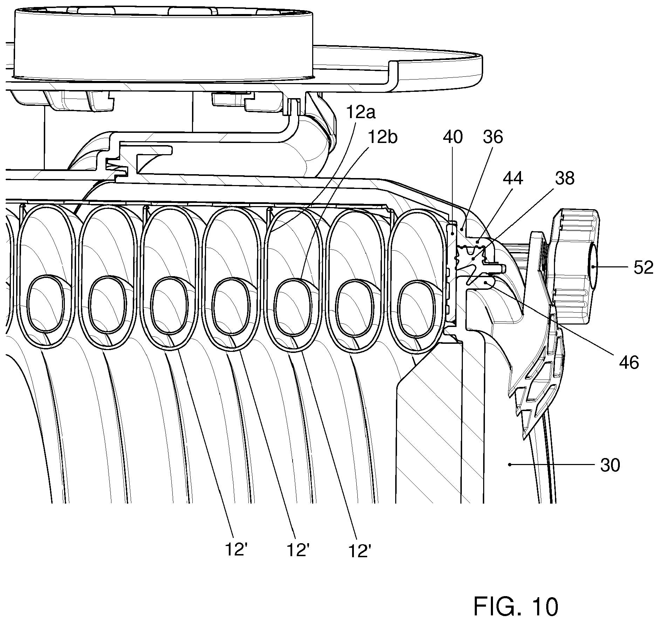

As a result of the levelling ring 40, the coil shaped heat exchanger pipe assembly 12 can be manufactured in a particularly simple manner. The coil windings 12' of the heat exchanger pipe assembly 12 that are located at the axial ends do not need to be especially flattened or otherwise shaped in order for the end faces of the coil shaped heat exchanger pipe assembly 12 to extend perpendicular to the central axis L. Also the space that is present between the exit free end of the heat exchanger pipe assembly 12 that forms the outlet 16 and the coil shaped winding 12' that is closest to the burner cover 30 can be bridged with the help of the levelling ring 40. To that end, the levelling ring 40 is provided with the rising surface 42 which is clearly visible in Figure 6. The side of the levelling ring 40 facing away from the heat exchanger pipe assembly 12 thus provides a smooth surface of flowing configuration. Being made from heat conducting material, the levelling ring 40 abutting against the burner cover 30 moreover provides a greater heating surface so that the cooling of the radial outer area of the burner cover 30 proceeds optimally and throughout the circumference. As a result of the cooled radial outer area of the burner cover, the cover seal 38 between the burner cover 30 and the opening edge in the second end wall 36 of the housing 20, 21 can be made from a material that does not need to be particularly heat resistant. Such a cover seal 38 can therefore be of relatively inexpensive design and moreover is less exposed to temperature fluctuations, which is favorable to the useful life of the cover seal 38. Moreover, due to the presence of the levelling ring 40, the burner cover opening in the second end wall 36 can have a relatively large diameter, since the annular second end wall 36 can engage the radial outer area of the levelling ring 40 and via that levelling ring 40 transfer the axial clamping force to the heat exchanger pipe assembly 12. Even when the coil windings 12' have a relatively strongly rounded cross section, as is visible in Figures 9 and 10, the inner diameter of the burner cover opening in the second end wall 36 can be relatively large without an effective clamping of the heat exchanger pipe assembly 12 being lost, since the axial clamping force transfer from the second end wall 36 can proceed in an effective manner via the levelling ring 40. A large inner diameter of the burner cover opening in the second end wall 36 is favorable because a relatively large radial outer area of the burner cover 30 is then in direct heat exchanging contact with the levelling ring 40. As a result, the radial outer area of the burner cover can be effectively cooled, which is of relevance to limiting as much as possible the heat loading of the cover seal 38 and of the second housing part 21 by the relatively warm burner cover 30.

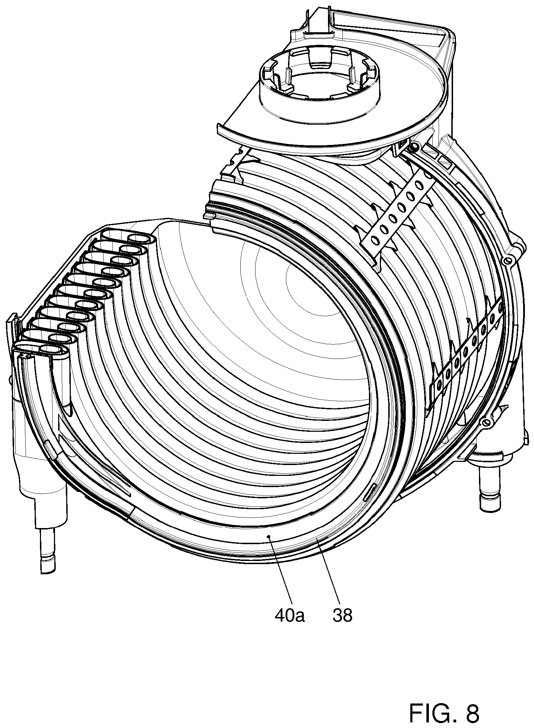

In an embodiment, of which an example is shown in the figures, the cover seal 38 may be located on the side 40a of the levelling ring 40 facing away from the heat exchanger pipe assembly 12. See in particular Figures 8, 9 and 10. Due to this cover seal 38 in this embodiment abutting against a relatively smooth surface of flowing configuration, there too a sealing is provided in a relatively simple manner. Thus, a third leakage flow of flue gases is stopped, namely, flue gas coming from the burner chamber part 18 that is seeking to escape to the flue gas transport gap 24. The smooth surface of flowing configuration moreover provides support to the cover seal 38 throughout the circumference thereof, so that it remains in place properly.

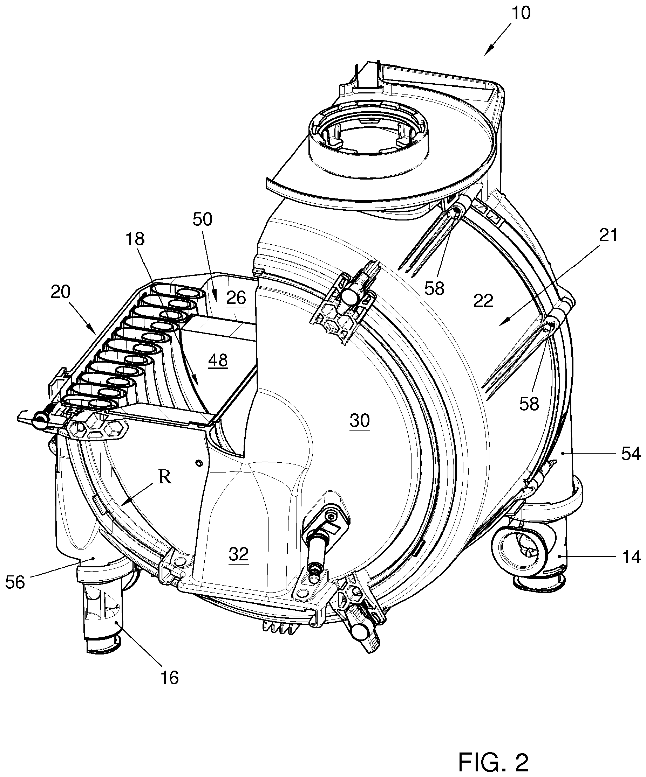

In an embodiment, of which an example is shown in the figures, the burner cover 30, at the location of the area where the levelling ring 40 abuts against the burner cover 30, may be provided with a relief whose shape corresponds to the shape of levelling ring 40 with the rising surface 42. The relief in the burner cover 30 is most clearly seen in Figure 2 and is designated there with arrow R.

Due to the burner cover 30 being provided with a relief, the axial dimension of the heat exchanger assembly 10, that is, the depth of the heat exchanger viewed in the direction of the axis L, can be kept relatively small because the burner cover 30 only needs to have an elevation adjacent the outlet 16. The remainder of the burner cover 30 can substantially extend adjacent the coil winding 12' that is closest to the burner cover 30. A small axial dimension of the heat exchanger assembly 10 is of great relevance in connection with the overall dimensions that are necessary for the heat exchanger assembly 10 regarding installation.

In an embodiment, of which an example is visible in Figures 9 and 10, the cover seal 38 is clamped between a cylindrical wall part 44 of the second end wall 36, extending parallel to the central axis, and a cylindrical wall part 46 of the burner cover 30, extending parallel to the central axis. As a result of such a radial clamping, a relative displacement of the burner cover 30 with respect to the housing 20, 21 in the direction of the central axis L has no influence on the sealing action of the cover seal 38. This in contrast to what is known from US2006/0196450 A1 in which the seal is clamped in axial direction. The sealing action of the radially clamped cover seal 38 is independent of the clamping force between burner cover 30 and housing 20, 21. The close-off action of the seal is therefore determined exclusively by the shape of the two cylindrical wall parts 44, 46 and not anymore by the amount of the tension of the fastening means with the help of which the burner cover 30 is connected with the housing 20, 21. Even when the fastening means are insufficiently tightened, the sealing is therefore not adversely affected. As a result, the tensioning means can be of simple design, for example using a snap connection that requires only a quarter turn rotation of a tensioning knob 52. Such a tensioning knob 52 may for instance be provided with a run-on cam which upon rotation of the tensioning knob 52 through 90 degrees brings the tensioning knob 52 from a released condition into a tightened condition. Such a manner of mounting the burner cover 30 on the housing 20, 21 is quick and reliable because the position of the tensioning knobs 52 indicates whether the fastening is tightened.

In an embodiment, of which an example is shown in the figures and is visible in Figures 1 and 2, the heat exchanger assembly 10 may comprise a partition plate 48 which extends parallel to the first 26 and the second 36 end wall and which separates the inner space that is bounded by the heat exchanger pipe assembly 12 into the burner chamber part 18 and a flue gas discharge part 50. The burner chamber part 18 of the inner space extends between the burner cover 30 and an upstream side of the partition plate 48. The flue gas discharge part 50 of the inner space extends from a downstream side of the partition plate 48 in the direction of the second end wall 36. In use, flue gases produced by the burner 34 flow via the burner chamber part 18 between the coil windings 12' located on the upstream side of the partition plate 48, into the flue gas transport gap 24. Thereupon, the flue gases flow between the coil windings 12' that are located on the downstream side of the partition plate 48 and thereby leave the flue gas transport gap and end up in the flue gas discharge part 50, then to leave the housing 20, 21 via the exhaust 28 for flue gases.

With such a construction a two-stage heat transfer of the heat of the flue gases to the medium in the heat exchanger pipe assembly 12 is obtained. What can thus be accomplished is that in the second stage a further-reaching condensation of the water vapor present in the flue gases is effected, leading to a heat exchanger with a particularly high efficiency.

In an embodiment, the housing 20, 21 may be divided into the first 20 and the second 21 housing part by a separating plane extending obliquely to the central axis L. Then the first housing part 20, in addition to the first end wall 26, further includes a part of the circumferential wall 22. The circumferential wall 22 of the first housing part 20 has a low side and a high side. In the low side of the first housing part 20 there is a first pipe assembly lead-through 54. Then the second housing part 21, in addition to the second end wall 36, further includes a part of the circumferential wall 22. The circumferential wall 22 of the second housing part 21 likewise has a low side and a high side. In the low side of the second housing part 21 there is a second pipe assembly lead-through 56.

Due to the pipe assembly lead-throughs 54, 56 being situated in the low side of the circumferential wall 22 of the respective housing parts 20, 21, the heat exchanger pipe assembly 12 can be placed in the first housing part 20 in a simple manner and thereupon the second housing part 21 can be placed over the heat exchanger pipe assembly 12 in a simple manner for connection with the first housing part 20. Thereupon the two housing parts can be connected to each other with, for example, screws or bolts 58 (see Figure 2) which extend in axial direction of the heat exchanger assembly 10. When under the influence of the internal fluid pressure in the heat exchanger pipe assembly 12 the heat exchanger pipe assembly 12 tends to expand in axial direction, the screws or bolts 58 which also extend in axial direction are under strain of tension, which is favorable on constructional grounds.

In an embodiment, the coil shaped heat exchanger pipe assembly 12 can comprise an outer tube 12a and an inner tube 12b (see Figures 9 and 10). The outer tube 12a can then be a first medium carrying duct and the inner tube 12b can be a second medium carrying duct. In an embodiment, the outer tube 12a can be, for example, a central heating water carrying duct and the inner tube 12b can be a sanitary water carrying duct.

The invention is not limited in any way to the above-described embodiments nor to the example shown in the figures. It is possible, for instance, that the heat exchanger pipe assembly 12 comprises a number of sub-heat exchanger pipe assemblies placed in line in axial direction, each having their own inlet and outlet. Further, it is possible that more than one partition plate is set up in the inner space bounded by the heat exchanger assembly 12, to form a multi-stage heat exchanger where the flue gas passes the inner space and the circumferential gap more than once.

The various embodiments which have been described above can be applied independently of each other and be combined with each other in different ways. The reference numerals in the detailed description and the claims do not limit the description of the embodiments and the claims and serve for clarification only.

## Claims

1. A heat exchanger assembly (10) comprising:
- at least one coil shaped heat exchanger pipe assembly (12) for passing through a fluid to be heated, wherein the heat exchanger pipe assembly (12) has an inlet (14) and an outlet (16) and wherein the heat exchanger pipe assembly (12) comprises coil windings (12') which extend concentrically around a coil axis (L), wherein the heat exchanger pipe assembly (12) on a radial inner side bounds an inner space which comprises a burner chamber part (18);
- a housing (20, 21) in which the heat exchanger pipe assembly is received, wherein the housing comprises:
∘ a circumferential wall (22) which is substantially cylindrical and which defines a housing axis which substantially coincides with the coil axis (L), wherein an inner diameter of the circumferential wall (22) is greater than an outer diameter of the heat exchanger pipe assembly (12), such that a flue gas transport gap (24) extends between the heat exchanger pipe assembly (12) and the circumferential wall (22);
∘ a first end wall (26) which closes off a first end of the circumferential wall (22);
∘ a second end wall (36) which closes off a second end of the circumferential wall (22) at least partially and comprises a central burner cover opening; and
∘ an exhaust (28) for flue gases;
wherein the heat exchanger assembly (10) further comprises:
- a burner cover (30) which is detachably connected with the second end wall (36) of the housing (20, 21), which burner cover (30) closes off the central burner cover opening and comprises an air/fuel mixture connection (32);
- a burner (34) which is connected with the burner cover (30) and which extends substantially concentrically around a burner axis which substantially coincides with the housing axis and the coil axis (L), wherein the burner (34) is situated in the burner chamber part (18), and wherein the burner (34) is in fluid communication with the air/fuel mixture connection (32);
wherein, in use, flue gases produced by the burner (34) flow via the burner chamber part (18) between said coil windings (12') into the flue gas transport gap (24) and wherein the flue gases eventually leave the housing (20, 21) via the exhaust (28);
**characterized in that:**
- the housing (20, 21) is divided in a first (20) and a second (21) housing part which are both made from plastic,
- the first housing part (20) includes the first end wall (26);
- the second housing part (21) includes the second end wall (36);
- the first and/or the second housing part (20 and/or 21) include the circumferential wall (22);
- the heat exchanger pipe assembly (12) is clamped in axial direction between the first (26) and the second (36) plastic end wall of the housing (20, 21);
wherein axial expansion forces exerted by the coil shaped heat exchanger pipe assembly (12), which occur in use as a result of an internal fluid pressure, are absorbed by the plastic first and second end walls (26, 36) of the housing (20, 21).

2. The heat exchanger assembly according to claim 1, wherein the burner cover opening has a diameter that is greater than an inner diameter of the heat exchanger pipe assembly (12), wherein a radial outer area of the burner cover (30) is in heat exchanging contact with the heat exchanger pipe assembly (12), such that in use the radial outer area of the burner cover (30) is cooled by the heat exchanger pipe assembly (12).

3. The heat exchanger assembly according to claim 2, wherein a cover seal (38) is confined between the cooled radial outer area of the burner cover (30) and a part of the second, plastic end wall (36) that bounds the central burner cover opening.

4. The heat exchanger assembly according to any one of claims 1-3, comprising:
- a levelling ring (40) having a rising surface (42), wherein the levelling ring (40) is situated between a coil winding (12') that extends closest to burner cover (30) and the burner cover (30), wherein a side (40a) of the levelling ring (40) facing the burner cover (30) forms a first contact face which abuts in heat conducting contact against the burner cover (30), wherein a side (40b) of the levelling ring (40) facing the heat exchanger pipe assembly (12) forms a second contact face which abuts in heat conducting contact against the coil winding (12') that extends closest to the burner cover (30), and wherein the levelling ring (40) is made from heat conducting material.

5. The heat exchanger assembly according to claim 4 when dependent on claim 3, wherein the cover seal (38) is located on the side (40a) of the levelling ring (40) that faces away from the heat exchanger pipe assembly (12).

6. The heat exchanger assembly according to claim 4 or 5, wherein the burner cover (30), at the location of the area where the levelling ring (40) abuts against the burner cover (30), is provided with a relief whose shape corresponds to the shape of the levelling ring (40) that comprises the rising surface (42).

7. The heat exchanger assembly according to claim 3, optionally in combination with any one of claims 4-6, wherein the cover seal (38) is clamped between a cylindrical wall part (44) of the second end wall (36) which extends substantially parallel to the central axis direction and a cylindrical wall part (46) of the burner cover (30) which extends substantially parallel to the central axis, such that a relative displacement of the burner cover (30) with respect to the housing (20, 21) in the direction of the central axis (L) has substantially no influence on the sealing action of the cover seal (38).

8. The heat exchanger assembly according to any one of claims 1-7, comprising:
- a partition plate (48) which extends parallel to the first (26) and the second (36) end wall and which separates the inner space which is bounded by the heat exchanger pipe assembly (12) into the burner chamber part (18) and a flue gas discharge part (50), wherein the burner chamber part (18) of the inner space extends between the burner cover (30) and an upstream side of the partition plate (48), and wherein the flue gas discharge part (50) of the inner space extends from a downstream side of the partition plate (48) in the direction of the second end wall (36);
wherein, in use, flue gases produced by the burner (34) flow via the burner chamber part (18) between said coil windings (12') that are situated on the upstream side of the partition plate (48) into the flue gas transport gap (24) and wherein the flue gases thereupon flow between said coil windings (12') that are situated on the downstream side of the partition plate (48) and thereby leave the flue gas transport gap and end up in the flue gas discharge part (50) to then leave the housing (20, 21) via the exhaust (28) for flue gases.

9. The heat exchanger assembly according to any one of the preceding claims, wherein the housing (20, 21) is divided into the first (20) and the second (21) housing part by a separating plane extending obliquely to the central axis (L), wherein the first housing part (20), in addition to the first end wall (26), further includes a part of the circumferential wall (22), wherein the circumferential wall (22) of the first housing part (20) has a low side and a high side, wherein a first pipe assembly lead-through (54) is situated in the low side of the first housing part (20), wherein the second housing part (21), in addition to the second end wall (36), further includes a part of the circumferential wall (22), wherein the circumferential wall (22) of the second housing part (21) has a low side and a high side, wherein a second pipe assembly lead-through (56) is situated in the low side of the second housing part (21).

10. The heat exchanger assembly according to any one of the preceding claims, wherein the coil shaped heat exchanger pipe assembly (12) comprises an outer tube (12a) and an inner tube (12b), wherein the outer tube (12a) is a first medium carrying duct and wherein the inner tube (12b) is a second medium carrying duct.

11. The heat exchanger assembly according to claim 10, wherein the outer tube (12a) is a central heating water carrying duct and wherein the inner tube (12b) is a sanitary water carrying duct.

## Patentansprüche

1. Wärmetauscheranordnung (10), umfassend:
- wenigstens eine spulenförmige Wärmetauscherrohranordnung (12) zum Durchleiten eines zu erhitzenden Fluids, wobei die Wärmetauscherrohranordnung (12) einen Einlass (14) und einen Auslass (16) aufweist und wobei die Wärmetauscherrohranordnung (12) Spulenwicklungen (12') umfasst, die sich konzentrisch um eine Spulenachse (L) erstrecken, wobei die Wärmetauscherrohranordnung (12) auf einer radialen Innenseite einen Innenraum begrenzt, der einen Brennerkammerteil (18) umfasst;
- ein Gehäuse (20, 21), in dem die Wärmetauscherrohranordnung aufgenommen ist, wobei das Gehäuse umfasst:
∘ eine Umfangswand (22), die im Wesentlichen zylindrisch ist und eine Gehäuseachse definiert, die im Wesentlichen mit der Spulenachse (L) zusammenfällt, wobei ein Innendurchmesser der Umfangswand (22) größer ist als ein Außendurchmesser der Wärmetauscherrohranordnung (12), so dass sich ein Rauchgastransportspalt (24) zwischen der Wärmetauscherrohranordnung (12) und der Umfangswand (22) erstreckt;
∘ eine erste Endwand (26), die ein erstes Ende der Umfangswand (22) abschließt;
∘ eine zweite Endwand (36), die ein zweites Ende der Umfangswand (22) wenigstens teilweise abschließt, und eine zentrale Brennerabdeckungsöffnung umfasst; und
∘ eine Auslassöffnung (28) für Rauchgase;
wobei die Wärmetauscheranordnung (10) ferner umfasst:
- eine Brennerabdeckung (30), die mit der zweiten Endwand (36) des Gehäuses (20, 21) abnehmbar verbunden ist, wobei die Brennerabdeckung (30) die zentrale Brennerabdeckungsöffnung abschließt und einen Luft-/Brennstoff-Gemischanschluss (32) umfasst;
- einen Brenner (34), der mit der Brennerabdeckung (30) verbunden ist und der sich im Wesentlichen konzentrisch um eine Brennerachse erstreckt, die im Wesentlichen mit der Gehäuseachse und der Spulenachse (L) zusammenfällt, wobei sich der Brenner (34) in dem Brennerkammerteil (18) befindet und wobei der Brenner (34) in Fluidverbindung mit dem Luft-/Brennstoff-Gemischanschluss (32) steht;
wobei im Gebrauch vom Brenner (34) erzeugte Rauchgase über den Brennerkammerteil (18) zwischen den Spulenwicklungen (12') in den Rauchgastransportspalt (24) strömen, und wobei die Rauchgase schließlich das Gehäuse (20, 21) über die Auslassöffnung (28) verlassen;
**dadurch gekennzeichnet, dass**
- das Gehäuse (20, 21) in einen erste (20) und einen zweite (21) Gehäuseteil unterteilt ist, die beide aus Kunststoff bestehen;
- der erste Gehäuseteil (20) die erste Endwand (26) einschließt;
- der zweite Gehäuseteil (21) die zweite Endwand (36) einschließt;
- der erste und/oder der zweite Gehäuseteil (20 und/oder 21) die Umfangswand (22) einschließen;
- die Wärmetauscherrohranordnung (12) in axialer Richtung zwischen der ersten (26) und der zweiten (36) Kunststoffendwand des Gehäuses (20, 21) eingespannt ist;
wobei axiale Expansionskräfte, die von der spulenförmigen Wärmetauscherrohranordnung (12) ausgeübt werden und im Gebrauch infolge eines inneren Fluiddrucks auftreten, von der ersten und zweiten Kunststoffendwand (26, 36) des Gehäuses (20, 21) absorbiert werden.

2. Wärmetauscheranordnung nach Anspruch 1, wobei die Brennerabdeckungsöffnung einen Durchmesser aufweist, der größer als ein Innendurchmesser der Wärmetauscherrohranordnung (12) ist, wobei sich ein radialer Außenbereich der Brennerabdeckung (30) in Wärmeaustauschkontakt mit der Wärmetauscherrohranordnung (12) befindet, so dass im Gebrauch der radiale Außenbereich der Brennerabdeckung (30) durch die Wärmetauscherrohranordnung (12) gekühlt wird.

3. Wärmetauscheranordnung nach Anspruch 2, wobei eine Abdeckungsdichtung (38) zwischen dem gekühlten radialen Außenbereich der Brennerabdeckung (30) und einem Teil der zweiten Kunststoffendwand (36), die die zentrale Brennerabdeckungsöffnung begrenzt, eingeschlossen ist.

4. Wärmetauscheranordnung nach einem der Ansprüche 1 bis 3, umfassend:
- einen Nivellierring (40) mit einer ansteigenden Oberfläche (42), wobei sich der Nivelliering (40) zwischen einer Spulenwicklung (12') befindet, die sich am nächsten an der Brennerabdeckung (30) und der Brennerabdeckung (30) erstreckt, wobei eine Seite (40a) des Nivellierrings (40), die der Brennerabdeckung (30) zugewandt ist, eine erste Kontaktfläche bildet, die in wärmeleitendem Kontakt gegen die Brennerabdeckung (30) anliegt, wobei eine Seite (40b) des Nivellierrings (40), die der Wärmetauscherrohranordnung (12) zugewandt ist, eine zweite Kontaktfläche bildet, die in einem wärmeleitendem Kontakt gegen die Spulenwicklung (12') anliegt, die sich am nächsten zur Brennerabdeckung (30) erstreckt und wobei der Nivellierring (40) aus wärmeleitendem Material besteht.

5. Wärmetauscheranordnung nach Anspruch 4, wenn abhängig von Anspruch 3, wobei sich die Abdeckungsdichtung (38) auf der Seite (40a) des Nivellierrings (40) befindet, die von der Wärmetauscherrohranordnung (12) weg zeigt.

6. Wärmetauscheranordnung nach Anspruch 4 oder 5, wobei die Brennerabdeckung (30) an der Stelle des Bereichs, an dem der Nivellierring (40) an der Brennerabdeckung (30) anliegt, mit einem Relief versehen ist, dessen Form der Form des Nivellierrings (40) entspricht, der die ansteigende Oberfläche (42) umfasst.

7. Wärmetauscheranordnung nach Anspruch 3, gegebenenfalls in Kombination mit einem der Ansprüche 4 bis 6, wobei die Abdeckdichtung (38) zwischen einem zylindrischen Wandteil (44) der zweiten Endwand (36) eingespannt ist, der sich im Wesentlichen parallel zur Mittelachsenrichtung und einem zylindrischen Wandteil (46) der Brennerabdeckung (30) erstreckt, der sich im Wesentlichen parallel zur Mittelachse erstreckt, so dass eine relative Verschiebung der Brennerabdeckung (30) gegenüber dem Gehäuse (20, 21) in Richtung der Mittelachse (L) im Wesentlichen keinen Einfluss auf die Dichtwirkung der Abdeckungsdichtung (38) hat.

8. Wärmetauscheranordnung nach einem der Ansprüche 1 bis 7, umfassend:
- eine Trennplatte (48), die sich parallel zur ersten (26) und zweiten (36) Endwand erstreckt und den Innenraum, der durch die Wärmetauscherrohranordnung (12) begrenzt ist, in den Brennerkammerteil (18) und einen Rauchgasaustrittsteil (50) trennt, wobei sich der Brennerkammerteil (18) des Innenraums zwischen der Brennerabdeckung (30) und einer stromaufwärtigen Seite der Trennplatte (48) erstreckt und wobei sich der Rauchgasaustrittsteil (50) des Innenraums von einer stromabwärtigen Seite der Trennplatte (48) in Richtung der zweiten Endwand (36) erstreckt; wobei im Gebrauch vom Brenner (34) erzeugte Rauchgase über den Brennerkammerteil (18) zwischen den Spulenwicklungen (12'), die sich auf der stromaufwärtigen Seite der Trennplatte (48) befinden, in den Rauchgastransportspalt (24) strömen, und wobei die Rauchgase daraufhin zwischen den Spulenwicklungen (12') strömen, die sich auf der stromabwärtigen Seite der Trennplatte (48) befinden und dadurch den Rauchgastransportspalt verlassen und in den Rauchgasaustrittsteil (50) gelangen, um dann das Gehäuse (20, 21) über die Auslassöffnung (28) für Rauchgase zu verlassen.

9. Wärmetauscheranordnung nach einem der vorhergehenden Ansprüche, wobei das Gehäuse (20, 21) durch eine sich schräg zur Mittelachse (L) erstreckende Trennebene in den ersten (20) und den zweiten (21) Gehäuseteil unterteilt ist, wobei der erste Gehäuseteil (20) zusätzlich zu der ersten Endwand (26) ferner einen Teil der Umfangswand (22) einschließt, wobei die Umfangswand (22) des ersten Gehäuseteils (20) eine niedrige Seite und eine hohe Seite aufweist, wobei eine erste Rohranordnungsdurchführung (54) auf der unteren Seite des ersten Gehäuseteils (20) angeordnet ist; wobei der zweite Gehäuseteil (21) zusätzlich zu der zweiten Endwand (36) ferner einen Teil der Umfangswand (22) umfasst, wobei die Umfangswand (22) des zweiten Gehäuseteils (21) eine untere Seite und eine hohe Seite aufweist, wobei sich eine zweite Rohranordnungsdurchführung (56) auf der unteren Seite des zweiten Gehäuseteils (21) befindet.

10. Wärmetauscheranordnung nach einem der vorhergehenden Ansprüche, wobei die spulenförmige Wärmetauscherrohranordnung (12) ein Außenrohr (12a) und ein Innenrohr (12b) umfasst, wobei das Außenrohr (12a) ein erster Mediumführkanal ist und wobei das Innenrohr (12b) ein zweiter Mediumführkanal ist.

11. Wärmetauscheranordnung nach Anspruch 10, wobei das Außenrohr (12a) ein zentraler Heizwasserführkanal ist und wobei das Innenrohr (12b) ein Sanitärerwasserführkanal ist.

## Revendications

1. Ensemble d'échangeur de chaleur (10) comprenant :
- au moins un ensemble de tube échangeur de chaleur en forme de serpentin (12) destiné à faire passer un fluide à chauffer, dans lequel l'ensemble de tube échangeur de chaleur (12) a une entrée (14) et une sortie (16) et dans lequel l'ensemble de tube échangeur de chaleur (12) comprend des spires de serpentin (12') qui s'étendent de façon concentrique autour d'un axe de serpentin (L), dans lequel l'ensemble de tube échangeur de chaleur (12), sur un côté intérieur radial, délimite un espace intérieur qui comprend une partie de chambre de brûleur (18) ;
- un boîtier (20, 21) dans lequel est placé l'ensemble de tube échangeur de chaleur, le boîtier comprenant :
• une paroi circonférentielle (22) qui est substantiellement cylindrique et qui définit un axe de boîtier qui coïncide substantiellement avec l'axe de serpentin (L), dans lequel un diamètre intérieur de la paroi circonférentielle (22) est plus grand qu'un diamètre extérieur de l'ensemble de tube échangeur de chaleur (12), de sorte qu'un espace de transport de gaz de combustion (24) s'étend entre l'ensemble de tube échangeur de chaleur (12) et la paroi circonférentielle (22) ;
• une première paroi d'extrémité (26) qui ferme une première extrémité de la paroi circonférentielle (22) ;
• une deuxième paroi d'extrémité (36) qui ferme une deuxième extrémité de la paroi circonférentielle (22) au moins partiellement et qui comprend une ouverture centrale de couvercle de brûleur ; et
• un échappement (28) pour les gaz de combustion ;
dans lequel l'ensemble d'échangeur de chaleur (10) comprend en outre :
- un couvercle de brûleur (30) qui est connecté de manière détachable à la deuxième paroi d'extrémité (36) du boîtier (20, 21), lequel couvercle de brûleur (30) ferme l'ouverture centrale de couvercle de brûleur et comprend une connexion de mélange air/combustible (32) ;
- un brûleur (34) qui est connecté au couvercle de brûleur (30) et qui s'étend de façon substantiellement concentrique autour d'un axe de brûleur qui coïncide substantiellement avec l'axe de boîtier et l'axe de serpentin (L), dans lequel le brûleur (34) est situé dans la partie de chambre de brûleur (18), et dans lequel le brûleur (34) est en communication fluide avec la connexion de mélange air/combustible (32) ;
dans lequel, en utilisation, les gaz de combustion produits par le brûleur (34) circulent via la partie de chambre de brûleur (18) entre lesdites spires de serpentin (12') et entrent dans l'espace de transport de gaz de combustion (24) et dans lequel les gaz de combustion quittent finalement le boîtier (20, 21) par l'échappement (28) ;
**caractérisé en ce que** :
- le boîtier (20, 21) est divisé en une première (20) et une deuxième (21) partie de boîtier qui sont toutes les deux en matière plastique,
- la première partie de boîtier (20) comprend la première paroi d'extrémité (26) ;
- la deuxième partie de boîtier (21) comprend la deuxième paroi d'extrémité (36) ;
- la première et/ou la deuxième partie de boîtier (20 et/ou 21) comprend la paroi circonférentielle (22) ;
- l'ensemble de tube échangeur de chaleur (12) est coincé dans la direction axiale entre la première (26) et la deuxième (36) paroi d'extrémité en plastique du boîtier (20, 21) ;
dans lequel les forces de dilatation axiale exercées par l'ensemble de tube échangeur de chaleur en forme de serpentin (12), qui se produisent en utilisation en conséquence d'une pression de fluide interne, sont absorbées par les première et deuxième parois d'extrémité en plastique (26, 36) du boîtier (20, 21).

2. Ensemble d'échangeur de chaleur selon la revendication 1, dans lequel l'ouverture de couvercle de brûleur a un diamètre qui est plus grand qu'un diamètre intérieur de l'ensemble de tube échangeur de chaleur (12), dans lequel une surface extérieure radiale du couvercle de brûleur (30) est en contact d'échange thermique avec l'ensemble de tube échangeur de chaleur (12), de sorte qu'en utilisation la surface extérieure radiale du couvercle de brûleur (30) est refroidie par l'ensemble de tube échangeur de chaleur (12).

3. Ensemble d'échangeur de chaleur selon la revendication 2, dans lequel un joint de couvercle (38) est confiné entre la surface extérieure radiale refroidie du couvercle de brûleur (30) et une partie de la deuxième paroi d'extrémité en plastique (36) qui délimite l'ouverture centrale de couvercle de brûleur.

4. Ensemble d'échangeur de chaleur selon l'une quelconque des revendications 1 à 3, comprenant :
- une bague de réglage (40) ayant une surface montante (42), dans lequel la bague de réglage (40) se situe entre une spire de serpentin (12') qui est la plus proche du couvercle de brûleur (30) et le couvercle de brûleur (30), dans lequel un côté (40a) de la bague de réglage (40) faisant face au couvercle de brûleur (30) forme une première surface de contact qui prend appui en contact de conduction de chaleur sur le couvercle de brûleur (30), dans lequel un côté (40b) de la bague de réglage (40) faisant face à l'ensemble de tube échangeur de chaleur (12) forme une deuxième face de contact qui prend appui en contact de conduction de chaleur sur la spire de serpentin (12') qui est la plus proche du couvercle de brûleur (30), et dans lequel la bague de réglage (40) est faite d'un matériau conducteur de la chaleur.

5. Ensemble d'échangeur de chaleur selon la revendication 4 lorsqu'elle dépend de la revendication 3, dans lequel le joint de couvercle (38) se trouve du côté (40a) de la bague de réglage (40) qui est à l'écart de l'ensemble de tube échangeur de chaleur (12).

6. Ensemble d'échangeur de chaleur selon la revendication 4 ou 5, dans lequel le couvercle de brûleur (30), à l'endroit de la surface où la bague de réglage (40) prend appui sur le couvercle de brûleur (30), est pourvu d'un relief dont la forme correspond à la forme de la bague de réglage (40) qui comprend la surface montante (42).

7. Ensemble d'échangeur de chaleur selon la revendication 3, éventuellement en association avec l'une quelconque des revendications 4 à 6, dans lequel le joint de couvercle (38) est coincé entre une partie de paroi cylindrique (44) de la deuxième paroi d'extrémité (36) qui s'étend substantiellement parallèlement à la direction d'axe central et une partie de paroi cylindrique (46) du couvercle de brûleur (30) qui s'étend substantiellement parallèlement à l'axe central, de telle manière qu'un déplacement relatif du couvercle de brûleur (30) par rapport au boîtier (20, 21) dans la direction de l'axe central (L) n'a substantiellement pas d'influence sur l'action d'étanchéité du joint de couvercle (38).

8. Ensemble d'échangeur de chaleur selon l'une quelconque des revendications 1 à 7, comprenant :
- une plaque de séparation (48) qui s'étend parallèlement à la première (26) et à la deuxième (36) paroi d'extrémité et qui divise l'espace intérieur qui est délimité par l'ensemble de tube échangeur de chaleur (12) en la partie de chambre de brûleur (18) et une partie de refoulement de gaz de combustion (50), dans lequel la partie de chambre de brûleur (18) de l'espace intérieur s'étend entre le couvercle de brûleur (30) et un côté amont de la plaque de séparation (48), et dans lequel la partie de refoulement de gaz de combustion (50) de l'espace intérieur s'étend depuis un côté aval de la plaque de séparation (48) dans la direction de la deuxième paroi d'extrémité (36) ;
dans lequel, en utilisation, les gaz de combustion produits par le brûleur (34) circulent via la partie de chambre de brûleur (18) entre lesdites spires de serpentin (12') qui sont situées en amont de la plaque de séparation (48) et entrent dans l'espace de transport de gaz de combustion (24) et dans lequel les gaz de combustion circulent ensuite entre lesdites spires de serpentin (12') qui sont situées en aval de la plaque de séparation (48) et quittent ainsi l'espace de transport de gaz de combustion et finissent dans la partie de refoulement de gaz de combustion (50) pour quitter ensuite le boîtier (20, 21) par l'échappement (28) pour gaz de combustion.

9. Ensemble d'échangeur de chaleur selon l'une quelconque des revendications précédentes, dans lequel le boîtier (20, 21) est divisé en la première (20) et la deuxième (21) partie de boîtier par un plan de séparation qui s'étend en oblique par rapport à l'axe central (L), dans lequel la première partie de boîtier (20), en plus de la première paroi d'extrémité (26), comprend en outre une partie de la paroi circonférentielle (22), dans lequel la paroi circonférentielle (22) de la première partie de boîtier (20) a un côté inférieur et un côté supérieur, dans lequel une première traversée d'ensemble de tube (54) se situe dans le côté inférieur de la première partie de boîtier (20), dans lequel la deuxième partie de boîtier (21), en plus de la deuxième paroi d'extrémité (36), comprend en outre une partie de la paroi circonférentielle (22), dans lequel la paroi circonférentielle (22) de la deuxième partie de boîtier (21) a un côté inférieur et un côté supérieur, dans lequel une deuxième traversée d'ensemble de tube (56) se situe dans le côté inférieur de la deuxième partie de boîtier (21).

10. Ensemble d'échangeur de chaleur selon l'une quelconque des revendications précédentes, dans lequel l'ensemble de tube échangeur de chaleur en forme de serpentin (12) comprend un tube extérieur (12a) et un tube intérieur (12b), dans lequel le tube extérieur (12a) est une première conduite de transport de milieu et dans lequel le tube intérieur (12b) est une deuxième conduite de transport de milieu.

11. Ensemble d'échangeur de chaleur selon la revendication 10, dans lequel le tube extérieur (12a) est une conduite de transport d'eau de chauffage central et dans lequel le tube intérieur (12b) est une conduite de transport d'eau sanitaire.
